# EUROPÄISCHE PATENTSCHRIFT

(11) **EP 1 378 062 B1**
(45) Veröffentlichungstag und Bekanntmachung des Hinweises auf die Patenterteilung: **31.05.2006**
(21) Anmeldenummer: 02721997.1
(22) Anmeldetag: 08.03.2002
(51) Int. Cl.: H03M 1/00

(54) **RÜCKGEKOPPELTER A/D- BZW. D/A-WANDLER MIT REDUZIERTEM STROMVERBRAUCH**
FEEDBACK A/D- OR D/A-CONVERTER WITH REDUCED CURRENT CONSUMPTION
CONVERTISSEUR A/N OU N/A A RETROACTION PRESENTANT UNE FAIBLE CONSOMMATION ELECTRIQUE

(30) Priorität: 11.04.2001 DE 10118157
(43) Veröffentlichungstag der Anmeldung: 07.01.2004
(73) Patentinhaber: Infineon Technologies AG, 81669 München (DE)
(72) Erfinder: DÖRRER, Lukas, A-9600 Villach (AT); HÖLLINGER, Werner, A-9500 Villach (AT)
(74) Vertreter: Graf Lambsdorff, Matthias
(86) Internationale Anmeldenummer: PCT/DE2002/000828
(87) Internationale Veröffentlichungsnummer: WO 2002/084880

(56) Entgegenhaltungen:
- DE-A- 4 311 724
- US-A- 5 541 600

## Beschreibung

Die vorliegende Erfindung bezieht sich auf rückgekoppelte A/D- und D/A-Wandler, welche durch eine Skalierung der Referenzsignale einen im Vergleich zu bisherigen A/D- und D/A-Wandlern reduzierten Stromverbrauch aufweisen. Insbesondere betrifft die Erfindung Sigma-Delta-A/D- und Sigma-Delta-D/A-Wandler.

Ein A/D-Wandler (Analog to Digital Converter, ADC) dient zur Umwandlung eines analogen Signals in ein digitales Signal. Im umgekehrten Fall wird ein D/A-Wandler (Digital to Analog Converter, DAC) zur Umwandlung eines digitalen Signals in ein analoges Signal herangezogen.

Beim Umsetzen von dem Analog- in den Digitalbereich bezieht sich ein A/D-Wandler auf eine Referenzspannung. Die Referenzspannung gibt im allgemeinen die Proportionalitätskonstante zwischen einer den A/D-Wandler speisenden Eingangsspannung und der ausgegebenen digitalen Größe an. Entsprechendes gilt für D/A-Wandler. A/D- und D/A-Wandler sind aus dem Kapitel 18 "DA- und AD-Umsetzer" des Buchs "Halbleiter-Schaltungstechnik" von Ulrich Tietze und Christoph Schenk, Springer Berlin 1999, ISBN 3-540-64192-0 bekannt. Dieses Kapitel wird hiermit in den Offenbarungsgehalt der vorliegenden Patentanmeldung aufgenommen.

Bei einem rückgekoppelten A/D-Wandler wird von dem Ausgang des A/D-Wandlers ein Signalpfad einem D/A-Wandler zugeführt. An einem Summationspunkt wird das aus dem D/A-Wandler ausgegebene analoge Signal von dem analogen Eingangssignal des rückgekoppelten A/D-Wandlers subtrahiert. Das aus dem Summationspunkt ausgegebene Differenzsignal speist den Eingang des A/D-Wandlers. Ein rückgekoppelter D/A-Wandler ergibt sich aus einem rückgekoppelten A/D-Wandler durch Vertauschen des A/D-Wandlers mit dem D/A-Wandler.

Aus der deutschen Offenlegungsschrift DE 43 11 724 A1 ist ein rückgekoppelter A/D-Wandler gemäß dem Oberbegriff des Anspruchs 1 bekannt.

Zu der Gruppe der rückgekoppelten A/D- und D/A-Wandler gehören auch die Sigma-Delta-A/D- und -D/A-Wandler. Ein Sigma-Delta-A/D-Wandler weist im Vergleich zu dem oben beschriebenen rückgekoppelten A/D-Wandler als zusätzliches Merkmal einen dem D/A-Wandler nachgeschalteten Integrator auf. Sigma-Delta-A/D- und D/A-Wandler sind aus dem Buch "Digitale Audiosignalverarbeitung" von Udo Zölzer, Teubner Stuttgart 1997, ISBN 3-519-16180-X bekannt. Insbesondere werden Sigma-Delta-Wandler dort im Kapitel 3 "AD/DA-Umsetzung" beschrieben. Dieses Buch wird hiermit ebenfalls in den Offenbarungsgehalt der vorliegenden Patentanmeldung aufgenommen.

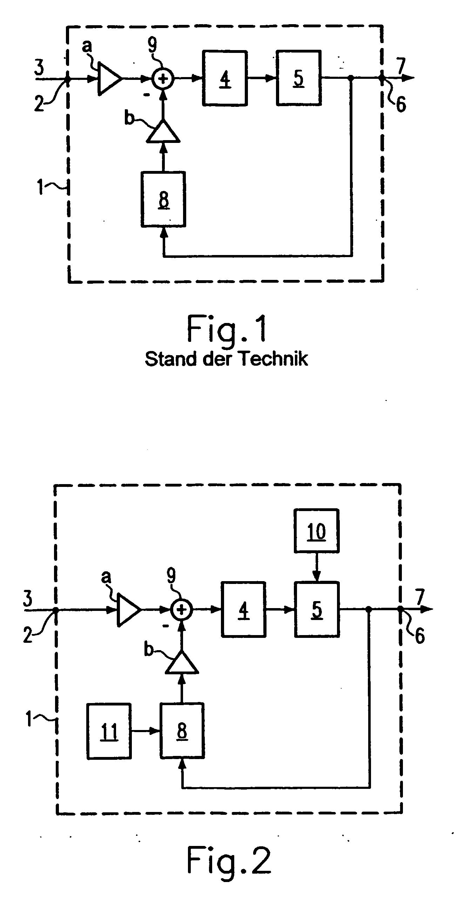

In Fig. 1 ist ein schematisches Schaltbild eines Sigma-Delta-A/D-Wandlers 1 dargestellt, wie er im Stand der Technik Verwendung findet. Der Sigma-Delta-A/D-Wandler 1 ist an einem Eingang 2 mit einem analogen Signal 3 beaufschlagt. Mittels eines Integrators 4 und eines Analog-Digital-Wandlers 5 erzeugt der Sigma-Delta-A/D-Wandler 1 an einem Ausgang 6 ein überabgetastetes digitales Signal 7 mit einer mittleren Spannung, die der Spannung des analogen Signals 3 entspricht. Ein Digital-Analog-Wandler 8 verwandelt das digitale Signal 7 in ein analoges Bezugssignal zurück, welches mit invertiertem Vorzeichen über einen Summationspunkt 9 zum Eingang des Integrators 4 rückgekoppelt wird.

In dem vorliegenden Schaltbild sind Verstärkungsfaktoren a und b angegeben. Die Verstärkungsfaktoren a und b sind im allgemeinen nicht als elektronische Bauelemente zu verstehen, sondern stehen jeweils für eine Verstärkung der Signale, die durch den zugehörigen Signalpfad übertragen werden. Beispielsweise können einer oder beide der verstärkungsfaktoren a und b in dem Integrator 4 schaltungstechnisch realisiert sein. In der Regel enthält der Integrator 4 einen Operationsverstärker, welcher mit einer Rückkoppelkapazität und einer geschalteten Eingangskapazität beschaltet ist. Eine mögliche schaltungstechnische Realisierung ist, daß ein Pol der Eingangskapazität mit einer gemeinsamen Masse beaufschlagt ist. Der andere Pol der Eingangskapazität wird durch geeignete Schaltmittel alternierend entweder mit dem Eingangssignal des Integrators 4 oder mit einem Eingang des Operationsverstärkers verbunden. Das Verhältnis der Eingangskapazität und der Rückkoppelkapazität bestimmt den Verstärkungsfaktor des Integrators 4 und damit die Größe des Verstärkungsfaktors a. In analoger Weise wird der Verstärkungsfaktor b realisiert. Die Verstärkungsfaktoren a und b bestimmen wiederum die Charakteristik des Regelkreises und sind für eine gewählte Architektur des Sigma-Delta-A/D-Wandlers 1 festgelegt bzw. nur in engen Grenzen frei wählbar. Große Verstärkungsfaktoren a und b bedingen ein großes Verhältnis der beiden Kapazitäten des Integrators 4. Mindestens eine der beiden Kapazitäten muß stets groß sein, da die kleinste Kapazität aus zwei Gründen nicht beliebig klein gemacht werden kann. Zum einen ist ein gutes Matching der Kapazitäten erforderlich, um eine geforderte Genauigkeit der Verstärkungsfaktoren a und b zu gewährleisten. Zum anderen erhöht eine kleine Kapazität das thermische Rauschen. Nachteilig an einer großen Kapazität ist jedoch, daß der Operationsverstärker des Integrators 4 eine große kapazitive Last treiben muß. Der Ausgangsstrom des Integrators 4 steigt proportional mit der Lastkapazität. Dadurch erhöht sich auch der Energiebedarf des Sigma-Delta-A/D-Wandlers 1 pro Zeiteinheit. Bei bekannten Sigma-Delta-A/D-Wandlern wird eine Verringerung des Energiebedarfs durch eine Reduzierung der Lastkapazität des Integrators bewirkt. Dadurch kann allerdings die Charakteristik des Sigma-Delta-A/D-Wandlers beeinflußt werden.

Andere rückgekoppelte A/D-Wandler weisen häufig ebenfalls signalverstärkende Bauelemente auf. Zur Reduzierung des Energiebedarfs werden bei bekannten rückgekoppelten A/D-Wandlern die Verstärkungsfaktoren der signalverstärkenden Bauelemente verkleinert. Nachteilig daran ist wiederum eine veränderte Charakteristik der Übertragungsfunktion des rückgekoppelten A/D-Wandlers.

Aufgabe der Erfindung ist es daher, einen rückgekoppelten A/D-Wandler bzw. einen Sigma-Delta-A/D-Wandler zu schaffen, dessen Energieverbrauch im Vergleich zu bekannten rückgekoppelten A/D-Wandlern bzw. bekannten Sigma-Delta-A/D-Wandlern abgesenkt ist. Dabei soll die Übertragungsfunktion des zu schaffenden rückgekoppelten A/D-Wandlers bzw. des zu schaffenden Sigma-Delta-A/D-Wandlers nicht wesentlich verändert werden. Die Erfindung soll insbesondere auch auf rückgekoppelte D/A-Wandler und Sigma-Delta-D/A- Wandler anwendbar sein.

Die der Erfindung zugrundeliegende Aufgabenstellung wird durch die Merkmale der unabhängigen Patentansprüche gelöst. Vorteilhafte Weiterbildungen und Ausgestaltungen sind in den Unteransprüchen angegeben.

Ein erfindungsgemäßer rückgekoppelter A/D-Wandler weist mindestens einen Analog-Digital-Wandler und mindestens einen Digital-Analog-Wandler in mindestens einer Rückkoppelschleife auf. Des weiteren umfaßt der rückgekoppelte A/D-Wandler erste Mittel zur Bereitstellung mindestens einer ersten Referenzspannung, auf welche sich der Analog-Digital-Wandler beim Umsetzen eines analogen Signals in ein digitales Signal bezieht, und zweite Mittel zur Bereitstellung mindestens einer zweiten Referenzspannung, auf welche sich der mindestens eine Digital-Analog-Wandler beim Umsetzen eines digitalen Signals in ein analoges Signal bezieht. Ein wesentlicher Gedanke der Erfindung besteht darin, daß die mindestens eine erste und die mindestens eine zweite Referenzspannung zur Erzeugung eines gewünschten Pegels eines Ausgangssignals des mindestens einen Analog-Digital-Wandlers auslegbar sind. Bei dem erfindungsgemäßen rückgekoppelten A/D-Wandler kann es sich um alle Arten von rückgekoppelten A/D-Wandlern handeln, wie z.B. um einen Nachlauf-A/D-Wandler (Tracking Analog to Digital Converter).

Unter einem Ausgangssignal eines elektrischen Bauelements oder Geräts kann entweder eine an dem Ausgang des betreffenden elektrischen Bauelements oder Geräts anliegende Spannung oder ein aus dem Ausgang auskoppelbarer Strom verstanden werden.

Bei dem erfindungsgemäßen rückgekoppelten A/D-Wandler können die mindestens eine erste und die mindestens eine zweite Referenzspannung derart ausgelegt werden, daß sie eine zusätzliche Verstärkung der Signale der mindestens einen Rückkoppelschleife bewirken. Dabei bewirken der mindestens eine Analog-Digital-Wandler und der mindestens eine Digital-Analog-Wandler jeder für sich noch keine Verstärkung, da sie jeweils lediglich einen Zahlenwert in ein anderes Zahlensystem umsetzen. Jedoch ergibt sich bei einer geeigneten Wahl der mindestens einen ersten und mindestens einen zweiten Referenzspannung durch das Zusammenwirken des mindestens einen Analog-Digital-Wandlers mit dem mindestens einen Digital-Analog-Wandler eine zusätzliche Verstärkung der mindestens einen Rückkoppelschleife. So bewirkt eine im Vergleich zur mindestens einen zweiten Referenzspannung kleinere mindestens eine erste Referenzspannung eine zusätzliche Verstärkung der mindestens einen Rückkoppelschleife, da die Verstärkung der mindestens einen Rückkoppelschleife mit einem wachsenden Quotienten aus der mindestens einen zweiten und der mindestens einen ersten Referenzspannung ebenfalls ansteigt. Dadurch ist es möglich, bei einer geeigneten Auslegung der mindestens einen ersten und der mindestens einen zweiten Referenzspannung am Ausgang des mindestens einem Analog-Digital-Wandlers eine gewünschte Übertragungsfunktion zu erzeugen. Damit ergeben sich veränderte signalverstärkende Bauelemente in der mindestens einen Rückkoppelschleife, welche gegenüber konventionellen rückgekoppelten A/D-Wandlern einen geringeren Energieverbrauch aufweisen. Durch die Erfindung wird folglich ein signalverstärkender Faktor der mindestens einen Rückkoppelschleife von dem Analogbereich in den Digitalbereich verschoben. Durch die gleichzeitige Änderung der Referenzen und der signalverstärkenden Bauelemente im Analogbereich kann der Energiebedarf des rückgekoppelten A/D-Wandlers sinken, es wird jedoch die Übertragungsfunktion beibehalten.

Erfindungsgemäß ist vorgesehen, daß der rückgekoppelte A/D-Wandler mindestens einen Verstärker enthält, welcher dem mindestens einen Analog-Digital-Wandler vorgeschaltet ist. Ferner sind die mindestens eine erste und die mindestens eine zweite Referenzspannung in Abhängigkeit von dem Verstärkungsfaktor des mindestens einen Verstärkers auslegbar. Der mindestens eine Verstärker erzeugt ausgangsseitig ein Signal, dessen Pegel dem Pegel des mit dem Verstärkungsfaktor multiplizierten Eingangssignals des mindestens einen Verstärkers entspricht.

Unter einem Verstärkungsfaktor kann das Verhältnis zwischen einem Ausgangssignal und einem Eingangssignal verstanden werden. Der Verstärkungsfaktor wird durch eine geeignete Wahl elektrischer Bauelemente realisiert.

Die Verstärkung der Signale der mindestens einen Rückkoppelschleife bekannter rückgekoppelter A/D-Wandler erfolgt durch eine geeignete Wahl des Verstärkungsfaktors des mindestens einen Verstärkers. Der erfindungsgemäße rückgekoppelte A/D-Wandler weist zusätzlich die ersten und zweiten Mittel auf, mit welchen sich die mindestens eine erste und die mindestens eine zweite Referenzspannung in Abhängigkeit von dem Verstärkungsfaktor des mindestens einen Verstärkers auslegen lassen. Die Verstärkung der mindestens einen Rückkoppelschleife ist erfindungsgemäß abhängig von dem Produkt aus dem Verstärkungsfaktor des mindestens einen Verstärkers und dem Quotienten aus der mindestens einen zweiten und der mindestens einen ersten Referenzspannung. Dadurch ist es möglich, bei einer geeigneten Auslegung der mindestens einen ersten und der mindestens einen zweiten Referenzspannung den Verstärkungsfaktor des mindestens einen Verstärkers zu verringern und dennoch die Verstärkung der mindestens einen Rückkoppelschleife des rückgekoppelten A/D-Wandlers im wesentlichen konstant zu halten. Diese Maßnahme führt zu einer Verringerung des Energiebedarfs des rückgekoppelten A/D-Wandlers, wobei die Übertragungsfunktion des rückgekoppelten A/D-Wandlers im wesentlichen erhalten bleibt.

Vorteilhafterweise weist der mindestens eine Verstärker elektrische Bauelemente auf, welche den Verstärkungsfaktor des mindestens einen Verstärkers bestimmen. Die elektrischen Bauelemente lassen sich bei einer geeigneten Auslegung der mindestens einen ersten und der mindestens einen zweiten Referenzspannung derart wählen, daß der Energieverbrauch des mindestens einen Verstärkers minimiert wird.

Eine weitere vorteilhafte Ausgestaltung der Erfindung ist dadurch gekennzeichnet, daß durch die ersten Mittel die mindestens eine erste Referenzspannung eingestellt wird, und durch die zweiten Mittel die mindestens eine zweite Referenzspannung eingestellt wird. Gemäß dieser Maßnahme werden die mindestens eine erste und die mindestens eine zweite Referenzspannung mit festen Größen in die Schaltung implementiert, sie können jedoch bei Bedarf auch variiert werden.

Der erfindungsgemäße Sigma-Delta-A/D-Wandler umfaßt mindestens einen Analog-Digital-Wandler, mindestens einen Digital-Analog-Wandler in mindestens einer Rückkoppelschleife und mindestens einen Integrator, welcher dem mindestens einen Digital-Analog-Wandler nachgeschaltet ist. Erste Mittel dienen zur Bereitstellung mindestens einer ersten Referenzspannung des mindestens einen Analog-Digital-Wandlers, und zweite Mittel dienen zur Bereitstellung mindestens einer zweiten Referenzspannung des mindestens einen Digital-Analog-Wandlers. Die mindestens eine erste und die mindestens-eine zweite Referenzspannung werden in Abhängigkeit vom dem Verstärkungsfaktor des mindestens einen Integrators ausgelegt.

Der erfindungsgemäße Sigma-Delta-A/D-Wandler weist entsprechende Vorteile wie der erfindungsgemäße rückgekoppelte A/D-Wandler auf. Es kann bei dem erfindungsgemäßen Sigma-Delta-A/D-Wandler mittels der ersten und zweiten Mittel die mindestens eine erste Referenzspannung kleiner als die mindestens eine zweite Referenzspannung gewählt werden, so daß dadurch die Verstärkung der mindestens einen Rückkoppelschleife erhöht wird. Gleichzeitig kann bei einer gewünschten Beibehaltung der Gesamtverstärkung der mindestens einen Rückkoppelschleife der Verstärkungsfaktor des mindestens einen Integrators reduziert werden. Der Verstärkungsfaktor des mindestens einen Integrators kann durch ein Kapazitätsverhältnis bestimmt sein. Eine Reduzierung des Kapazitätsverhältnisses ergibt einen verringerten Stromfluß durch den mindestens einen Integrator und damit einen verringerten Energieverbrauch des Sigma-Delta-A/D-Wandlers. Es kann auch vorgesehen sein, daß der mindestens eine Integrator mit mindestens einem Widerstand und/oder mindestens einer Kapazität beschaltet ist. Auch in diesem Fall kann der Verstärkungsfaktor und der Energieverbrauch des mindestens einen Integrators erfindungsgemäß verringert werden.

Der erfindungsgemäße Sigma-Delta-A/D-Wandler kann des weiteren eine kaskadierte Struktur aufweisen, wobei mindestens zwei erfindungsgemäße Sigma-Delta-A/D-Wandler entsprechend miteinander verschaltet sind.

Ein weiterer Aspekt der Erfindung betrifft ein Verfahren, welches sich auf einen rückgekoppelten A/D-Wandler anwenden läßt. Dazu umfaßt der rückgekoppelte A/D-Wandler mindestens einen Analog-Digital-Wandler und mindestens einen Digital-Analog-Wandler in mindestens einer Rückkoppelschleife. Bei dem erfindungsgemäßen Verfahren werden mindestens eine erste Referenzspannung, auf welche sich der mindestens eine Analog-Digital-Wandler beim Umsetzen eines analogen Signals in ein digitales Signal bezieht, und mindestens eine zweite Referenzspannung, auf welche sich der mindestens eine Digital-Analog-Wandler beim Umsetzen eines digitalen Signals in ein analoges Signal bezieht, bereitgestellt. Die mindestens eine erste und die mindestens eine zweite Referenzspannung werden dabei zur Erzeugung einer gewünschten Übertragungsfunktion des mindestens einen Analog-Digital-Wandlers ausgelegt. Diese Auslegung erfolgt vorteilhafterweise derart, daß der Energieverbrauch des rückgekoppelten A/D-Wandlers weitestgehend reduziert wird und trotzdem eine gewünschte Übertragungsfunktion des rückgekoppelten A/D-Wandlers erzielt wird. Beispielsweise kann die Energieeinsparung durch die Reduzierung des Verstärkungsfaktors eines signalverstärkenden Bauelements erzielt werden.

In analoger Weise zu dem vorstehenden erfindungsgemäßen rückgekoppelten A/D-Wandler, dem dazugehörigen erfindungsgemäßen Verfahren und dem erfindungsgemäßen Sigma-Delta-A/D-Wandler bezieht sich die Erfindung auch auf einen rückgekoppelten D/A-Wandler, ein entsprechendes Verfahren und einen Sigma-Delta-D/A-Wandler. Die Vorteile dieser Erfindung entsprechen den bereits oben erwähnten Vorteilen.

Die Erfindung wird nachfolgend unter Bezugnahme auf die Zeichnungen näher erläutert. In diesen zeigen:
- Fig. 1: ein schematisches Schaltbild eines Sigma-Delta-A/D-Wandlers gemäß dem Stand der Technik;
- Fig. 2: ein schematisches Schaltbild eines Ausführungsbeispiels des erfindungsgemäßen Sigma-Delta-A/D-Wandlers; und
- Fig. 3: ein schematisches Schaltbild eines Ausführungsbeispiels des erfindungsgemäßen kaskadierten Sigma-Delta-A/D-Wandlers.

Das in Fig. 2 gezeigte Ausführungsbeispiel der Erfindung entspricht in einigen Teilen dem in Fig. 1 dargestellten bekannten Sigma-Delta-A/D-Wandler. An einem Eingang 2 eines Sigma-Delta-A/D-Wandlers 1 wird ein analoges Signal 3 eingekoppelt. Ein Integrator 4 und ein nachfolgender Analog-Digital-Wandler 5 erzeugen ein digitales Signal 7, welches dem analogen Signal 3 entspricht und an einem Ausgang 6 abgegriffen oder ausgekoppelt werden kann. In einer Rückkoppelschleife, welche einen Digital-Analog-Wandler 8 aufweist, wird das digitale Signal 7 wieder in ein analoges Bezugssignal umgesetzt und mit invertiertem Vorzeichen zu dem analogen Signal 3 in einem Summationspunkt 9 hinzuaddiert. Das Summensignal wird dem Eingang des Integrators 4 zugeführt. Die Verstärkung des Ausgangssignals des Integrators 4 kann mittels Verstärkungsfaktoren a und b eingestellt werden.

Im Gegensatz zu dem in Fig. 1 gezeigten Sigma-Delta-A/D-Wandler enthält das vorliegende Ausführungsbeispiel der Erfindung eine Einheit 10, mit welcher sich die Referenzspannung des Analog-Digital-Wandlers 5 einstellen läßt, und eine Einheit 11, mit welcher sich die Referenzspannung des Digital-Analog-Wandlers 8 einstellen läßt. Wird beispielsweise die Referenzspannung des Digital-Analog-Wandlers 8 derart eingestellt, daß sie die Referenzspannung des Analog-Digital-Wandlers 5 übertrifft, so wird ein Signal, welches den von dem Analog-Digital-Wandler 5 und dem Digital-Analog-Wandler 8 bestimmten Signalpfad durchläuft, verstärkt. Um die ursprüngliche Verstärkung des von dem Integrator 4 ausgegebenen Signals bzw. des digitalen Signals 7, welche vor der Einstellung der Referenzspannungen durch die Einheiten 10 und 11 gegeben war, wiederherzustellen, können die Verstärkungsfaktoren b und/oder a des Integrators 4 entsprechend verringert werden, wobei der Integrator 4 unter Umständen auch weitere Verstärkungsfaktoren aufweisen kann, die ebenfalls eingestellt werden können. Dieses kann beispielsweise durch eine Verringerung des Kapazitätsverhältnisses des Integrators 4 erfolgen.

Dadurch nimmt der Ausgangsstrom des Integrators 4 ab und eine Energieeinsparung ist die Folge.

Des weiteren kann vorgesehen sein, daß ein erfindungsgemäßer rückgekoppelter A/D-Wandler bzw. Sigma-Delta-A/D-Wandler ein rückgekoppelter A/D-Wandler bzw. Sigma-Delta-A/D-Wandler höherer Ordnung ist. In diesem Fall enthielte der rückgekoppelte A/D-Wandler bzw. Sigma-Delta-A/D-Wandler weitere Rückkoppelschleifen mit weiteren Digital-Analog-Wandlern sowie eventuell weitere Integratoren, wobei eventuell jeder der Digital-Analog-wandler und jeder der Analog-Digital-Wandler unterschiedliche Referenzspannungen aufweist. Der Grad der Ordnung eines rückgekoppelten A/D-Wandlers bzw. Sigma-Delta-A/D-Wandlers wird durch die Anzahl der Rückkoppelschleifen bestimmt. Entsprechendes gilt auch für den erfindungsgemäßen rückgekoppelten D/A-Wandler bzw. Sigma-Delta-D/A-Wandler.

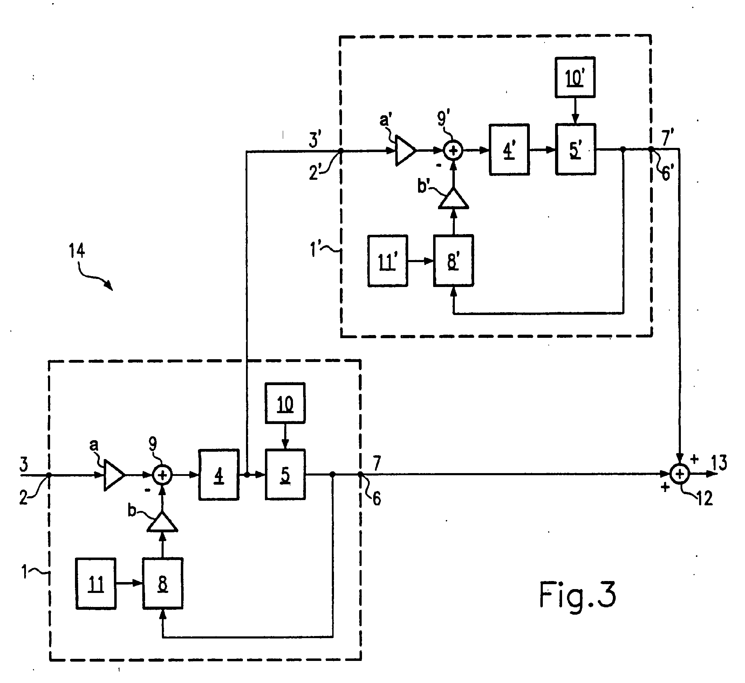

In Fig. 3 ist das schematische Schaltbild eines kaskadierten Sigma-Delta-A/D-Wandlers 14 mit erfindungsgemäßen Merkmalen dargestellt. Der kaskadierte Sigma-Delta-A/D-Wandler 14 enthält Sigma-Delta-A/D-Wandler 1 und 1', die jeweils die gleiche Struktur wie der in Fig. 2 gezeigte Sigma-Delta-A/D-Wandler 1 aufweisen. Zusätzlich speist in dem vorliegenden schematischen Schaltbild das Ausgangssignal des Integrators 4 des Sigma-Delta-A/D-Wandlers 1 den Eingang 2' des Sigma-Delta-A/D-Wandlers 1'. Die von den Sigma-Delta-A/D-Wandlern 1 und 1' erzeugten digitalen Signale 7 und 7' werden an einem Summationspunkt 12 addiert und liefern ein digitales Signal 13, welches das Ausgangssignal des kaskadierten Sigma-Delta-A/D-Wandlers 14 ist.

## Patentansprüche

1. Rückgekoppelter A/D-Wandler, welcher mindestens einen Analog-Digital-Wandler (5) und mindestens einen Digital-Analog-Wandler (8) in mindestens einer Rückkoppelschleife aufweist, und welcher ferner aufweist
- erste Mittel zur Bereitstellung mindestens einer ersten Referenzspannung des mindestens einen Analog-Digital-Wandlers (5) und zweite Mittel zur Bereitstellung mindestens einer zweiten Referenzspannung des mindestens einen Digital-Analog-Wandlers (8), wobei die mindestens eine erste und die mindestens eine zweite Referenzspannung zur Erzeugung eines gewünschten Pegels eines Ausgangssignals des mindestens einen Analog-Digital-Wandlers (5) ausgelegt werden,
**gekennzeichnet durch**
- mindestens einen Verstärker, welcher dem mindestens einen Analog-Digital-Wandler (5) vorgeschaltet ist, wobei die mindestens eine erste und die mindestens eine zweite Referenzspannung in Abhängigkeit von dem Verstärkungsfaktor (a, b) des mindestens einen Verstärkers ausgelegt wird,
wobei
- der Pegel eines Ausgangssignals der Rückkoppelschleife und der Pegel eines Ausgangssignals des Analog-Digital-Wandlers (5) Funktionen des Produkts aus dem Verstärkungsfaktor (b und/oder a) des Verstärkers und dem Quotienten aus der mindestens einen zweiten und der mindestens einen ersten Referenzspannung sind.

2. Rückgekoppelter A/D-Wandler nach Anspruch 1,
**dadurch gekennzeichnet,**
- **daß** der mindestens eine Verstärker elektrische Bauelemente aufweist, durch welche der Verstärkungsfaktor (a, b) des mindestens einen Verstärkers bestimmt ist.

3. Rückgekoppelter A/D-Wandler nach Anspruch 1 oder 2,
**dadurch gekennzeichnet,**
- **daß** die ersten Mittel derart ausgelegt sind, daß durch sie die mindestens eine erste Referenzspannung eingestellt wird, und
- **daß** die zweiten Mittel derart ausgelegt sind, daß durch sie die mindestens eine zweite Referenzspannung eingestellt wird.

4. Sigma-Delta-A/D-Wandler (1), welcher einen rückgekoppelten A/D-Wandler nach Anspruch 1 aufweist, wobei der mindestens eine Verstärker des rückgekoppelten A/D-Wandlers durch mindestens einen Integrator (4) realisiert ist.

5. Sigma-Delta-A/D-Wandler (1) nach Anspruch 4,
**dadurch gekennzeichnet,**
- **daß** der mindestens eine Integrator (4) mindestens ein elektrisches Bauelement, insbesondere mindestens einen Widerstand und/oder mindestens einen Kondensator, aufweist, durch welches der Verstärkungsfaktor (a, b) des mindestens einen Integrators (4) bestimmt ist.

6. Sigma-Delta-A/D-Wandler (1) nach Anspruch 4 oder 5, **dadurch gekennzeichnet,**
- **daß** die ersten Mittel derart ausgelegt sind, daß durch sie die mindestens eine erste Referenzspannung eingestellt wird, und
- **daß** die zweiten Mittel derart ausgelegt sind, daß durch sie die mindestens eine zweite Referenzspannung eingestellt wird.

7. Kaskadierter Sigma-Delta-A/D-Wandler (14), welcher mindestens zwei Sigma-Delta-A/D-Wandler (1, 1') nach einem oder mehreren der Ansprüche 4 bis 6 in einer kaskadierten Verschaltung aufweist.

8. Rückgekoppelter D/A-Wandler, welcher mindestens einen Digital-Analog-Wandler und mindestens einen Analog-Digital-Wandler in mindestens einer Rückkoppelschleife aufweist, und ferner aufweist
- erste Mittel zur Bereitstellung mindestens einer ersten Referenzspannung des mindestens einen Digital-Analog-Wandlers und zweite Mittel zur Bereitstellung mindestens einer zweiten Referenzspannung des mindestens einen Analog-Digital-Wandlers, wobei die mindestens eine erste und die mindestens eine zweite Referenzspannung zur Erzeugung eines gewünschten Pegels eines Ausgangssignals des mindestens einen Digital-Analog-Wandlers ausgelegt werden,
**gekennzeichnet durch**
- mindestens einen Verstärker, welcher dem mindestens einen Digital-Analog-Wandler vorgeschaltet ist, wobei die mindestens eine erste und die mindestens eine zweite Referenzspannung in Abhängigkeit von dem Verstärkungsfaktor des mindestens einen Verstärkers ausgelegt werden, wobei
- der Pegel eines Ausgangssignals der mindestens einen Rückkoppelschleife und der Pegel eines Ausgangssignals des mindestens einen Digital-Analog-Wandlers Funktionen des Produkts aus dem Verstärkungsfaktor des mindestens einen Verstärkers und dem Quotienten aus der mindestens einen zweiten und der mindestens einen ersten Referenzspannung sind.

9. Rückgekoppelter D/A-Wandler nach Anspruch 8,
**dadurch gekennzeichnet,**
- **daß** der mindestens eine Verstärker elektrische Bauelemente aufweist, durch welche der Verstärkungsfaktor des mindestens einen Verstärkers bestimmt ist.

10. Rückgekoppelter D/A-Wandler nach Anspruch 8 oder 9,
**dadurch gekennzeichnet,**
- **daß** die ersten Mittel derart ausgelegt sind, daß durch sie die mindestens eine erste Referenzspannung eingestellt wird, und
- **daß** die zweiten Mittel derart ausgelegt sind, daß durch sie die mindestens eine zweite Referenzspannung eingestellt wird.

11. Sigma-Delta-D/A-Wandler, welcher einen rückgekoppelten D/A-Wandler nach Anspruch 8 aufweist, wobei der mindestens eine Verstärker des rückgekoppelten D/A-Wandlers durch mindestens einen Integrator realisiert ist.

12. Sigma-Delta-D/A-Wandler nach Anspruch 11,
**dadurch gekennzeichnet,**
- **daß** der mindestens eine Integrator mindestens ein elektrisches Bauelement, insbesondere mindesten einen Widerstand und/oder mindestens einen Kondensator, aufweist, durch welches der Verstärkungsfaktor des mindestens einen Integrators bestimmt ist.

13. Sigma-Delta-D/A-Wandler nach Anspruch 11 oder 12,
**dadurch gekennzeichnet,**
- **daß** die ersten Mittel derart ausgelegt sind, daß durch sie die mindestens eine erste Referenzspannung eingestellt wird, und
- **daß** die zweiten Mittel derart ausgelegt sind, daß durch sie die mindestens eine zweite Referenzspannung eingestellt wird.

14. Kaskadierter Sigma-Delta-D/A-Wandler, welcher mindestens zwei Sigma-Delta-D/A-Wandler nach einem oder mehreren der Ansprüche 11 bis 13 in einer kaskadierten Verschaltung aufweist.

15. Verfahren, anzuwenden auf einen rückgekoppelten A/D-Wandler, welcher mindestens einen Analog-Digital-Wandler (5) und mindestens einen Digital-Analog-Wandler (8) in mindestens einer Rückkoppelschleife aufweist, bei welchem
- mindestens eine erste Referenzspannung des mindestens einen Analog-Digital-Wandlers (5) und mindestens eine zweite Referenzspannung des mindestens einen Digital-Analog-Wandlers (8) bereitgestellt werden, wobei die mindestens eine erste und die mindestens eine zweite Referenzspannung zur Erzeugung eines gewünschten Pegels eines Ausgangssignals des mindestens einen Analog-Digital-Wandlers (5) ausgelegt werden,
**dadurch gekennzeichnet,**
- **daß** der rückgekoppelte A/D-Wandler mindestens einen Verstärker, welcher dem mindestens einen Analog-Digital-Wandler (5) vorgeschaltet ist, aufweist, wobei die mindestens eine erste und die mindestens eine zweite Referenzspannung in Abhängigkeit von dem Verstärkungsfaktor (a, b) des mindestens einen Verstärkers ausgelegt werden, wobei
- der Pegel eines Ausgangssignals der Rückkoppelschleife und der Pegel eines Ausgangssignals des Analog-Digital-Wandlers Funktionen des Produkts aus dem Verstärkungsfaktor (b und/oder a) des Verstärkers und dem Quotienten aus der mindestens einen zweiten und der mindestens einen ersten Referenzspannung sind.

16. Verfahren, anzuwenden auf einen rückgekoppelten D/A-Wandler, welcher mindestens einen Digital-Analog-Wandler und mindestens einen Analog-Digital-Wandler in mindestens einer Rückkoppelschleife aufweist, bei welchem
- mindestens eine erste Referenzspannung des mindestens einen Digital-Analog-Wandlers und mindestens eine zweite Referenzspannung des mindestens einen Analog-Digital-Wandlers bereitgestellt werden, wobei die mindestens eine erste und die mindestens eine zweite Referenzspannung zur Erzeugung eines gewünschten Pegels eines Ausgangssignals des mindestens einen Digital-Analog-Wandlers ausgelegt werden,
**dadurch gekennzeichnet,**
- **daß** der rückgekoppelte D/A-Wandler mindestens einen Verstärker, welcher dem mindestens einen Digital-Analog-Wandler vorgeschaltet ist, aufweist, wobei die mindestens eine erste und die mindestens eine zweite Referenzspannung in Abhängigkeit von dem Verstärkungsfaktor des mindestens einen Verstärkers ausgelegt werden, wobei
- der Pegel eines Ausgangssignals der mindestens einen Rückkoppelschleife und der Pegel eines Ausgangssignals des mindestens einen Digital-Analog-Wandlers Funktionen des Produkts aus dem Verstärkungsfaktor des mindestens einen Verstärkers und dem Quotienten aus der mindestens einen zweiten und der mindestens einen ersten Referenzspannung sind.

## Claims

1. Feedback A/D converter which has at least one analogue/digital converter (5) and at least one digital/analogue converter (8) in at least one feedback loop, and which also has
- first means for providing at least one first reference voltage for the at least one analogue/digital converter (5), and second means for providing at least one second reference voltage for the at least one digital/analogue converter (8), in which case the at least one first reference voltage and the at least one second reference voltage are designed to produce a desired output signal level from the at least one analogue/digital converter (5),
**characterized by**
- at least one amplifier which is connected upstream of the at least one analogue/digital converter (5), in which case the at least one first reference voltage and the at least one second reference voltage are designed to be dependent on the gain factor (a, b) of the at least one amplifier,
in which
- the level of an output signal from the feedback loop and the level of an output signal from the analogue/digital converter (5) are functions of the product of the gain factor (b and/or a) of the amplifier and the quotient of the at least one second reference voltage and the at least one first reference voltage.

2. Feedback A/D converter according to Claim 1,
**characterized**
- **in that** the at least one amplifier has electrical components which determine the gain factor (a, b) of the at least one amplifier.

3. Feedback A/D converter according to Claim 1 or 2,
**characterized**
- **in that** the first means are designed such that they are used to adjust the at least one first reference voltage, and
- **in that** the second means are designed such that they are used to adjust the at least one second reference voltage.

4. Sigma-delta A/D converter (1), which has a feedback A/D converter according to Claim 1, with the at least one amplifier of the feedback A/D converter being formed by at least one integrator (4).

5. Sigma-delta A/D converter (1) according to Claim 4,
**characterized**
- **in that** the at least one integrator (4) has at least one electrical component, in particular at least one resistor and/or at least one capacitor, which is or are used to determine the gain factor (a, b) of the at least one integrator (4).

6. Sigma-delta A/D converter (1) according to Claim 4 or 5,
**characterized**
- **in that** the first means are designed such that they are used to adjust the at least one first reference voltage, and
- **in that** the second means are designed such that they are used to adjust the at least one second reference voltage.

7. Cascaded sigma-delta A/D converter (14) which has at least two sigma-delta A/D converters (1, 1') according to one or more Claims 4 to 6 in a cascaded circuit.

8. Feedback D/A converter which has at least one digital/analogue converter and at least one analogue/digital converter in at least one feedback loop, and also has
- first means for providing at least one first reference voltage for the at least one digital/analogue converter, and second means for providing at least one second reference voltage for the at least one analogue/digital converter, in which case the at least one first reference voltage and the at least one second reference voltage are designed to produce a desired output signal level from the at least one digital/analogue converter,
**characterized by**
- at least one amplifier which is connected upstream of the at least one digital/analogue converter, in which case the at least one first reference voltage and the at least one second reference voltage are designed to be dependent on the gain factor of the at least one amplifier,
- the level of an output signal from the at least one feedback loop and the level of an output signal from the at least one digital/analogue converter are functions of the product of the gain factor of the at least one amplifier and the quotient of the at least one second reference voltage and the at least one first reference voltage.

9. Feedback D/A converter according to Claim 8,
**characterized**
- **in that** the at least one amplifier has electrical components which are used to determine the gain factor of the at least one amplifier.

10. Feedback D/A converter according to Claim 8 or 9,
**characterized**
- **in that** the first means are designed such that they are used to adjust the at least one first reference voltage, and
- **in that** the second means are designed such that they are used to adjust the at least one second reference voltage.

11. Sigma-delta D/A converter which has a feedback converter according to Claim 8, with the at least one amplifier of the feedback D/A converter being formed by at least one integrator.

12. Sigma-delta A/D converter according to Claim 6,
**characterized**
- **in that** the at least one integrator has at least one electrical component, in particular at least one resistor and/or at least one capacitor, which is or are used to determine the gain factor of the at least one integrator.

13. Sigma-delta D/A converter according to Claim 11 or 12,
**characterized**
- **in that** the first means are designed such that they are used to adjust the at least one first reference voltage, and
- **in that** the second means are designed such that they are used to adjust the at least one second reference voltage.

14. Cascaded sigma-delta D/A converter which has at least two sigma-delta D/A converters according to one or more of Claims 11 to 13 in a cascaded circuit.

15. Method which can be used for a feedback A/D converter which has at least one analogue/digital converter (5) and at least one digital/analogue converter (8) in at least one feedback loop, in which
- at least one first reference voltage for the at least one analogue/digital converter (5) and at least one second reference voltage for the at least one digital/analogue converter (8) are provided, in which case the at least one first reference voltage and the at least one second reference voltage are designed to produce a desired output signal level from the at least one analogue/digital converter (5),
**characterized**
- **in that** the feedback A/D converter has at least one amplifier which is connected upstream of the at least one analogue/digital converter (5), with the at least one first reference voltage and the at least one second reference voltage being designed to be dependent on the gain factor (a, b) of the at least one amplifier, the level of an output signal from the feedback loop and the level of an output signal from the analogue/digital converter being functions of the product of the gain factor (b and/or a) of the amplifier and the quotient of the at least one second reference voltage and the at least one first reference voltage..

16. Method which can be used for a feedback D/A converter which has at least one digital/analogue converter and at least one analogue/digital converter in at least one feedback loop, in which
- at least one first reference voltage for the at least one digital/analogue converter and at least one second reference voltage for the at least one analogue/digital converter are provided, with the at least one first reference voltage and the at least one second reference voltage being designed to produce a desired output signal level from the at least one digital/analogue converter,
**characterized**
- **in that** the feedback D/A converter has at least one amplifier which is connected upstream of the at least one digital/analogue converter, with the at least one first reference voltage and the at least one second reference voltage being designed to be dependent on the gain factor of the at least one amplifier, the level of an output signal from the at least one feedback loop and the level of an output signal from the at least one digital/analogue converter being functions of the product of the gain factor of the at least one amplifier and the quotient of the at least one second reference voltage and the at least one first reference voltage002E.

## Revendications

1. Convertisseur A/N à réaction qui a au moins un convertisseur (5) analogique-numérique et au moins un convertisseur (8) numérique-analogique dans au moins une boucle de réaction et qui a en outre
- des premiers moyens de mise à disposition d'au moins une première tension de référence du au moins un convertisseur (5) analogique-numérique et des deuxièmes moyens de mise à disposition d'au moins une deuxième tension de référence du au moins un convertisseur (8) numérique-analogique, la au moins une première et la au moins une deuxième tension de référence étant conçues pour produire un niveau souhaité d'un signal de sortie du au moins un convertisseur (5) analogique-numérique,
**caractérisé par**
- au moins un amplificateur qui est monté en amont du au moins un convertisseur (5) analogique-numérique, la au moins une première et la au moins une deuxième tension de référence étant conçues en fonction du coefficient (a, b) d'amplification du au moins un amplificateur,
dans lequel
- le niveau d'un signal de sortie de la boucle de réaction et le niveau d'un signal de sortie du convertisseur (5) analogique-numérique sont des fonctions du produit du coefficient (b et/ou a) d'amplification de l'amplificateur par le quotient de la au moins une deuxième par la au moins une première tension de référence.

2. Convertisseur A/N à réaction suivant la revendication 1,
**caractérisé**
- **en ce que** le au moins un amplificateur a des composants électriques par lesquels le coefficient (a, b) d'amplification du au moins un amplificateur est déterminé.

3. Convertisseur A/N à réaction suivant la revendication 1 ou 2,
**caractérisé**
- **en ce que** les premiers moyens sont conçus de manière à ce que la au moins une première tension de référence soit réglée par eux, et
- **en ce que** les deuxièmes moyens sont conçus de manière à ce que la au moins une deuxième tension de référence soit réglée par eux.

4. Convertisseur (1) A/N sigma-delta qui a un convertisseur A/N à réaction suivant la revendication 1, le au moins un amplificateur du convertisseur A/N à réaction étant réalisé par au moins un intégrateur (4).

5. Convertisseur (1) A/N sigma-delta suivant la revendication 4, **caractérisé**
- **en ce que** le au moins un intégrateur (4) a au moins un composant électrique, notamment au moins une résistance et/ou au moins un condensateur par lequel le coefficient (a, b) d'amplification du
au moins un intégrateur (4) est déterminé.

6. Convertisseur (1) A/N sigma-delta suivant la revendication 4 ou 5, **caractérisé**
- **en ce que** les premiers moyens sont conçus de manière à ce que la au moins une première tension de référence soit réglée par eux, et
- **en ce que** les deuxièmes moyens sont conçus de manière à ce que la au moins une deuxième tension de référence soit réglée par eux.

7. Convertisseur (14) A/N sigma-delta en cascade qui a au moins deux convertisseurs (1, 1') A/N sigma-delta suivant l'une ou plusieurs des revendications 4 à 6, suivant un câblage en cascade.

8. Convertisseur N/A à réaction qui a au moins un convertisseur numérique-analogique et au moins un convertisseur analogique-numérique dans au moins une boucle de réaction et qui a en outre
- des premiers moyens de mise à disposition d'au moins une première tension de référence du au moins un convertisseur numérique-analogique et des deuxièmes moyens de mise à disposition d'au moins une deuxième tension de référence du au moins un convertisseur analogique-numérique, la au moins une première et la au moins une deuxième tension de référence étant conçues pour produire un niveau souhaité d'un signal de sortie du au moins un convertisseur numérique-analogique,
**caractérisé par**
- au moins un amplificateur qui est monté en amont du au moins un convertisseur numérique-analogique, la au moins une première et la au moins une deuxième tension de référence étant conçues en fonction du coefficient (a, b) d'amplification du au moins un amplificateur,
dans lequel
- le niveau d'un signal de sortie de la boucle de réaction et le niveau d'un signal de sortie du convertisseur numérique-analogique sont des fonctions du produit du coefficient (b et/ou a) d'amplification de l'amplificateur par le quotient de la au moins une deuxième par la au moins une première tension de référence.

9. Convertisseur N/A à réaction suivant la revendication 8,
**caractérisé**
- **en ce que** le au moins un amplificateur a des composants électriques par lesquels le coefficient (a, b) d'amplification du au moins un amplificateur est déterminé.

10. Convertisseur N/A à réaction suivant la revendication 8 ou 9,
**caractérisé**
- **en ce que** les premiers moyens sont conçus de manière à ce que la au moins une première tension de référence soit réglée par eux, et
- **en ce que** les deuxièmes moyens sont conçus de manière à ce que la au moins une deuxième tension de référence soit réglée par eux.

11. Convertisseur N/A sigma-delta qui a un convertisseur N/A à réaction suivant la revendication 8, le au moins un amplificateur du convertisseur N/A à réaction étant réalisé par au moins un intégrateur.

12. Convertisseur N/A sigma-delta suivant la revendication 11, **caractérisé**
- **en ce que** le au moins un intégrateur a au moins un composant électrique, notamment au moins une résistance et/ou au moins un condensateur par lequel le coefficient (a, b) d'amplification du au moins un intégrateur est déterminé.

13. Convertisseur N/A sigma-delta suivant la revendication 11 ou 12, **caractérisé**
- **en ce que** les premiers moyens sont conçus de manière à ce que la au moins une première tension de référence soit réglée par eux, et
- **en ce que** les deuxièmes moyens sont conçus de manière à ce que la au moins une deuxième tension de référence soit réglée par eux.

14. Convertisseur N/A sigma-delta en cascade qui a au moins deux convertisseurs N/A sigma-delta suivant l'une ou plusieurs des revendications 11 à 13 dans un câblage en cascade.

15. Procédé à appliquer à un convertisseur A/N à réaction qui a au moins un convertisseur (5) analogique-numérique et au moins un convertisseur (8) numérique-analogique dans au moins une boucle de réaction, dans lequel
- on met à disposition au moins une première tension de référence du au moins un convertisseur (5) analogique-numérique et au moins une deuxième tension de référence du au moins un convertisseur (8) numérique-analogique, la au moins une première et la au moins une deuxième tension de référence étant conçues pour la production d'un niveau souhaité d'un signal de sortie du au moins un convertisseur (5) analogique-numérique,
**caractérisé**
- **en ce que** le convertisseur A/N à réaction a au moins un amplificateur qui est monté en amont d'au moins un convertisseur (5) analogique-numérique, la au moins une première et la au moins une deuxième tension de référence étant conçues en fonction du coefficient (a, b) d'amplification du au moins un amplificateur, le niveau d'un signal de sortie de la boucle de réaction et le niveau d' un signal de sortie du convertisseur analogique-numérique étant des fonctions du produit du coefficient (b et/ou a) d'amplification de l'amplificateur par le quotient de la au moins une deuxième par la au moins une première tension de référence.

16. Procédé à appliquer à un convertisseur N/A à réaction qui a au moins un convertisseur numérique-analogique et au moins un convertisseur analogique-numérique dans au moins une boucle de réaction, dans lequel
- on met à disposition au moins une première tension de référence du au moins un convertisseur numérique-analogique et au moins une deuxième tension de référence du au moins un convertisseur analogique-numérique, la au moins une première et la au moins une deuxième tension de référence étant conçues pour la production d'un niveau souhaité d'un signal de sortie du au moins un convertisseur numérique-analogique,
**caractérisé**
- **en ce que** le convertisseur N/A à réaction a au moins un amplificateur qui est monté en amont d'au moins un convertisseur numérique-analogique, la au moins une première et la au moins une deuxième tension de référence étant conçues en fonction du coefficient d'amplification du au moins un amplificateur, le niveau d'un signal de sortie de la boucle de réaction et le niveau d'un signal de sortie du convertisseur numérique-analogique étant des fonctions du produit du coefficient d'amplification de l'amplificateur par le quotient de la au moins une deuxième par la au moins une première tension de référence.
